# FASCICULE DE BREVET EUROPEEN

(11) **EP 2 735 035 B1**
(45) Date de publication et mention de la délivrance du brevet: **14.01.2015**
(21) Numéro de dépôt: 12733794.7
(22) Date de dépôt: 21.06.2012
(51) Int. Cl.: H01L 41/297, H01L 41/083, H01L 41/047, B06B 1/06

(54) **PROCÉDÉ D'ASSEMBLAGE D'UN TRANSDUCTEUR ULTRASONORE ET TRANSDUCTEUR OBTENU PAR LE PROCÉDÉ**
VERFAHREN ZUR MONTAGE EINES ULTRASCHALLKOPFES UND DAMIT HERGESTELLTER WANDLER
METHOD OF ASSEMBLING AN ULTRASONIC TRANSDUCER AND THE TRANSDUCER OBTAINED THEREBY

(30) Priorité: 18.07.2011 FR 1156506
(43) Date de publication de la demande: 28.05.2014
(73) Titulaire: Renault S.A.S., 92100 Boulogne-Billancourt (FR)
(72) Inventeur: LEVIN, Laurent, F-75015 Paris (FR); GRECA, Gustavo, F-94000 Creteil (FR)
(74) Mandataire: Rougemont, Bernard
(86) Numéro de dépôt international: PCT/FR2012/051411
(87) Numéro de publication internationale: WO 2013/011217

(56) Documents cités:
- EP-A2- 1 705 016
- DE-A1-102007 058 874
- DE-A1-102008 048 051

## Description

L'invention a pour objet un transducteur piézoélectrique ou magnétostrictif, notamment un transducteur apte à travailler à une fréquence ultrasonore.

Plus particulièrement, l'invention a pour objet un transducteur pouvant être utilisé comme actuateur d'un injecteur de carburant d'un moteur thermique.

Les injecteurs de carburant utilisant de tels actuateurs ultrasonores sont par exemple décrits dans les demandes de brevet FR 2 941 746, FR 2 936 025, FR 2 936 024, FR 2 918 123, FR 2 889 257. De tels injecteurs permettent de pulvériser très finement le carburant et d'optimiser la combustion d'un moteur à injection directe.

Une telle amélioration de la pulvérisation peut en particulier limiter la quantité de particules émises par le véhicule.

Un transducteur ultrasonore est typiquement composé d'un empilement ou « stack » dans lequel une couche de céramique piézoélectrique se trouve chaque fois placée "en sandwich" entre deux électrodes, connectées à deux bornes différentes d'une source d'alimentation électrique. Le domaine de fonctionnement (fréquence, force transmise) de transducteurs adaptés aux injecteurs de carburant, nécessite un empilement de céramiques relativement épaisses (typiquement de 1 à 5 mm d'épaisseur de céramique entre deux électrodes). De tels empilements peuvent être réalisés en empilant alternativement une épaisseur de céramique et une épaisseur d'électrode, sans matériau liant entre les deux épaisseurs. L'état de surface des céramiques et des électrodes doit alors être soigneusement rodé, avec une tolérance submicronique afin de limiter les concentrations de contrainte engendrées au niveau des zones de contact entre les électrodes et les céramiques, lors de la compression de l'empilement.

Le document DE102008048051 divulgue un procédé de fabrication d'un transducteur piézoélectrique comportant un empilement d'électrodes planes entre lesquelles sont interposées des tranches de céramique sensiblement de même surface que les électrodes, les contours superposés des tranches de céramique et des tranches d'électrodes définissant des faces latérales sensiblement planes ou cylindriques de l'empilement.

Le document EP1705016 divulgue un procédé de fabrication d'un transducteur piézoélectrique ne comportant pas un empilement d'électrodes planes entre lesquelles sont interposées des tranches de céramique dans le domaine technique du jet d'encre qui est différent de celui des injecteurs de carburant.

Afin de réduire les coûts de production, des méthodes de production alternatives sont proposées, comme par exemple de réaliser les électrodes par brasure d'une pâte composite, à base de poudre d'argent, la brasure étant apportée à une température d'environ 600° C entre deux couches de céramique successives.

L'état de surface de l'électrode est ainsi adapté à l'état de surface de la céramique. Cependant la température de brasure est alors supérieure à la température de Curie de la céramique piézoélectrique. Après l'opération de brasage, le transducteur doit donc être à nouveau soumis à un champ électrique élevé, afin de restaurer les propriétés piézoélectriques de la céramique. L'opération de repolarisation de la céramique s'accompagne de changements dimensionnels (gonflement) qui génèrent des contraintes résiduelles de cisaillement au niveau de l'interface entre l'électrode brasée et la céramique.

Les contraintes résiduelles accélèrent les mécanismes d'endommagement par fatigue, notamment par fissuration au niveau de l'interface, lors de l'utilisation du transducteur.

Outre des contraintes résiduelles induites par le brasage à l'interface entre la céramique et la pâte à braser, et des problèmes de dépolarisation, les températures de brasage élevées (de l'ordre de 600°C), si elles ne sont pas appliquée de manière suffisamment uniforme sur la céramique, peuvent également provoquer, par dilatation différentielle, des microfissures dans la céramique elle-même.

Des procédés utilisant de telles pâtes à braser sont par exemple décrits dans les demandes de brevet JP 2 985 503 et JP 6 084 409. Les pâtes à braser utilisées sont respectivement une pâte composite à base de poudre d'argent, et une pâte à braser composite à base de poudre céramique enrobée de particules d'argent submicroniques -c'est-à-dire des particules d'argent de 500 nm ou moins.

Dans ce dernier cas, la température de brasage peut être abaissée aux alentours de 300°C, mais les problèmes de dépolarisation des éléments de céramique persistent.

L'invention a pour but de proposer un procédé d'assemblage d'un transducteur, notamment d'un transducteur ultrasonore, qui évite d'effectuer une étape de repolarisation des céramiques après assemblage du transducteur. A cette fin, la température de la céramique doit pouvoir rester strictement inférieure à 300°C, et pendant les périodes où la céramique est exposée à une température supérieure à 100°C, les contraintes subies par la céramique ne doivent pas excéder 40 MPa afin de ne pas endommager la microstructure de la céramique.

A cette fin, un procédé de fabrication d'un transducteur piézoélectrique, notamment d'un transducteur ultrasonore, comprend les étapes suivantes. Ce procédé permet de fabriquer un empilement d'électrodes planes entre lesquelles sont interposées des tranches de céramique sensiblement de même surface que les électrodes, les contours superposés des tranches de céramique et des tranches d'électrodes définissant des faces latérales sensiblement planes ou cylindriques de l'empilement. Le procédé comprend notamment les étapes suivantes :
- on empile en les alternant une tranche de céramique et une tranche d'électrode, en apposant entre chaque tranche de céramique et ses deux électrodes voisines, une composition, comprenant au minimum 75% en poids, et de préférence au minimum 80% en poids de nanoparticules d'argent de taille de grains inférieure ou égale à 80 nanomètres, et de préférence de taille de grains inférieure ou égale à 60 nanomètres,
- on comprime l'empilement en le chauffant à une température inférieure ou égale à 280°C, et de préférence comprise entre 200°C et 250°C.

De manière préférentielle, la taille des nanoparticules d'argent est comprise entre 10 nanomètres et 60 nanomètres.

Avantageusement, la pression est appliquée de manière unidirectionnelle, perpendiculairement aux tranches de céramique, à une valeur comprise entre 2 et 20 MPa, et de préférence comprise entre 5 à 10 MPa, pendant une durée inférieure ou égale à 30 minutes et de préférence inférieure ou égale à 20 minutes.

Selon un mode de réalisation préférentiel, après apposition de la composition sur la céramique, la température moyenne de l'empilement est maintenue, c'est-à-dire maintenue pendant toute la durée du procédé jusqu'à obtention du transducteur fonctionnel, en dessous de 280°C, et de préférence en dessous de 250°C.

De manière préférentielle, la composition est une pâte. Par pâte, on entend ici une composition à base de poudre d'argent qui est suffisamment malléable, voire liquide, pour pourvoir être étalée sur un support plan. La pâte peut par exemple être obtenue en ajoutant des composants liquides, ou sous forme de gel, à la poudre de nanoparticules d'argent. On peut utiliser une pâte relativement fluide de manière à ce que sa surface libre soit toujours plane à l'état de repos, ce qui facilite une enduction régulière.

Dans un mode de mise en oeuvre préféré, pour apposer une couche de composition entre une tranche de céramique et une tranche d'électrode, on enduit un film support avec la composition, on vient poser le côté enduit du film support sur la céramique, puis on retire le film. On peut ainsi enduire une première face de la tranche de céramique, la poser sur une électrode, enduire de la même façon la seconde face de la tranche de céramique, et poser par-dessus la tranche de céramique une seconde électrode Avantageusement, avant de poser le film sur la céramique, on préchauffe la tranche de céramique à une température supérieure ou égale à 60°C, et de préférence supérieure ou égale à 100°C.

Selon une mode de réalisation préféré, on découpe un empilement initial perpendiculairement aux tranches de céramique, pour obtenir des empilements unitaires destinés à différents transducteurs, en gardant pour face latérale d'au moins un empilement, une portion de face latérale de l'empilement d'origine. Cette face latérale de l'empilement initial est donc utilisée sans rectification, usinage ou découpe de régularisation, pour former certaines surfaces des latérales définitives des transducteurs fabriqués à partir de l'empilement initial. Selon une variante de réalisation, l'empilement initial est utilisé intégralement pour fabriquer un seul transducteur, dont toutes les faces latérales sont des faces obtenues suite à l'opération de chauffage sous pression. Avantageusement, suite à l'opération de compression et chauffage, on nettoie les faces latérales par un procédé de type brossage ou sablage.

Les électrodes interposées entre les tranches de céramique et aux extrémités de l'empilement sont appelées électrodes intercalaires.

Selon un mode de réalisation préféré, on vient souder sur deux faces de l'empilement unitaire, chaque fois une électrode latérale qui est mise en contact avec une électrode intercalaire sur deux.

On peut utilisez des électrodes intercalaires présentant au moins une languette de connexion dimensionnée pour dépasser de l'empilement.

Selon un mode de réalisation avantageux, on utilise des électrodes intercalaires carrées présentant quatre languettes de connexion, dont deux premières languettes sur une première face du carré et deux secondes languettes sur une seconde face opposée du carré. On réalise l'empilement en décalant de +-90° chaque électrode par rapport à l'électrode précédente, et on découpe ensuite l'empilement en quatre empilements unitaires muni chacun de deux rangées de languettes sur deux faces adjacentes.

Selon un autre aspect, un transducteur ultrasonore obtenu par le procédé décrit, comprend un empilement de tranches de céramique et de tranches d'électrodes intercalaires, dans lequel :
- les tranches de céramique sont des couches épaisses d'au moins 1mm d'épaisseur, et de préférence d'au moins 2 mm d'épaisseur,
- les tranches d'électrode sont des couches métalliques en métal laminé ou en métal dense, d'au moins 20 micromètres d'épaisseur, de préférence d'au moins 50 micromètres d'épaisseur. Par métal dense, on entend un métal non poreux, obtenu par exemple par laminage ou forgeage à partir d'une masse coulée, par opposition à un métal fritté dont la structure laisse parfois subsister une trace des contours des grains initiaux de la poudre frittée, du fait de la distribution et/ou de la forme de certaines porosités résiduelles. Les électrodes peuvent être réalisées en alliage de cuivre-béryllium, en titane, en alliage de titane, ou argent ou en alliage d'argent. Avantageusement, l'électrode provient d'une tôle laminée, par exemple en argent laminé recuit. De manière préférentielle, les couches d'électrode ont une épaisseur inférieure ou égale à 1mm,
- entre chaque tranche de céramique et l'électrode voisine ou les électrodes voisines, est présente une couche intermédiaire d'argent d'épaisseur d'au moins 10 micromètres, et de préférence d'épaisseur comprise entre 15 et 50 micromètres, recouvrant au moins 95% d'une face de la tranche de céramique disposée en regard de l'électrode.

Par application du procédé décrit précédemment, on peut obtenir un empilement de transducteur dans lequel au moins une couche d'argent intermédiaire présente en moyenne un taux de porosité inférieur à 10% en surface sur une vue en coupe perpendiculaire aux tranches de céramique, et de préférence un taux de porosité inférieur ou égal à 5% en surface observée, les diamètres maximaux -i.e. les dimensions maximales- des porosités étant inférieurs ou égaux à 5 micromètres, et de préférence inférieurs ou égaux à 2 micromètres. On peut obtenir une l'interface entre la tranche de céramique et la couche d'argent qui est exempte de porosités sur plus de 90%, et de préférence, sur plus de 95% de la longueur d'interface. L'interface entre l'électrode intercalaire et la couche d'argent peut également présenter un excellent niveau de cohésion, typiquement est exempte de porosités sur plus de 90% de la longueur d'interface. En vue de ces quantifications, l'échantillon servant à l'observation doit bien entendu avoir été préparé avec suffisamment de précautions pour éviter de provoquer, a posteriori, une décohésion de la céramique d'avec la couche d'argent lors de la préparation de l'échantillon. On peut par exemple considérer que le taux de porosité observé de la couche d'argent et le taux de porosité observé aux interfaces de la couche d'argent, est représentatif, si la longueur de la portion de couche d'argent visible en coupe présente une longueur supérieure ou égale à 5mm. De manière préférentielle, le transducteur comporte uniquement des couches métalliques entre deux couches de céramique successives, c'est-à-dire l'électrode et la couche intermédiaire d'argent. Le métal de la couche intermédiaire d'argent est de préférence de l'argent pur à plus de 99%.

Selon un mode de réalisation préféré, le transducteur comporte deux électrodes latérales qui sont chacune en contact électrique avec une électrode intercalaire sur deux, c'est-à-dire avec une seule électrode intercalaire jouxtant une même tranche céramique. Chaque électrode latérale peut présenter une forme ondulée, de manière à laisser un intervalle d'au moins 0,5mm, et de préférence d'au moins 1mm, entre l'électrode latérale et les électrodes intercalaires auxquelles elle n'est pas connectée.

Selon un mode de réalisation avantageux, chaque électrode intercalaire comporte au moins une languette dépassant de l'empilement, le transducteur comportant deux électrodes latérales qui sont chacune en contact électrique avec la languette d'une électrode intercalaire sur deux.

Dans ce mode de réalisation, sur la face du transducteur longée par l'électrode latérale, les affleurements de la couche intermédiaire d'argent, sont rectilignes ou concaves sur une vue en coupe perpendiculaire aux tranches de céramique.

Selon un mode de réalisation préféré, les tranches de céramique sont des pastilles planes dont la plus petite dimension est de préférence supérieure ou égale à 7mm, et de préférence supérieure ou égale à 12mm, les pastilles étant recouvertes par la pâte d'argent sur une portion de leur surface supérieure ou égale à 99%.

Selon un mode de réalisation préféré, l'empilement présente une hauteur supérieure ou égale à 30mm. Pour ce faire, le transducteur comporte au moins six tranches de céramique dans l'empilement.

D'autres buts, caractéristiques et avantages de l'invention apparaîtront à la lecture de la description suivante, donnée uniquement à titre d'exemple non limitatif, et faite en référence aux dessins annexés, sur lesquels :
- la figure 1 est une vue de face d'un transducteur selon l'invention,
- la figure 2 est une vue en perspective du transducteur de la figure 1,
- la figure 3 est une vue d'un empilement réalisé lors de la fabrication d'un autre transducteur selon l'invention,
- la figure 4 est une vue schématique en coupe d'une portion de transducteur selon l'invention.

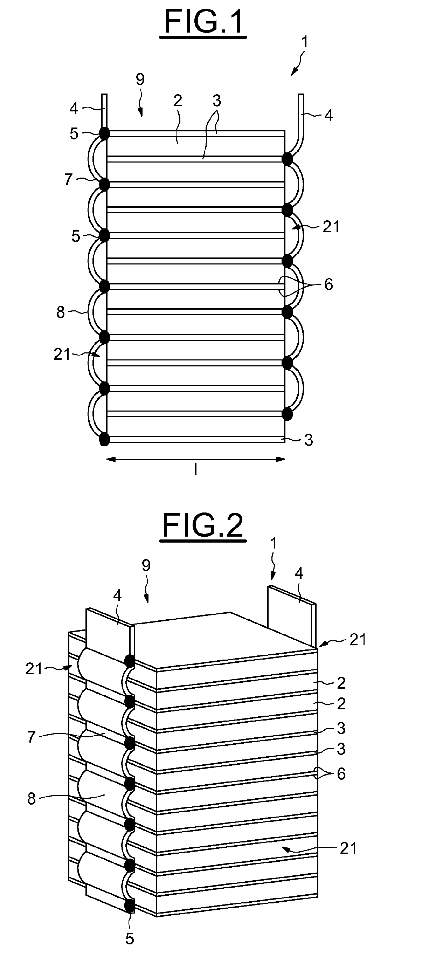

La figure 1 est une vue schématique d'un transducteur selon l'invention. Le transducteur 1 comprend des tranches 2 de céramique, par exemple de céramique piézoélectrique, alternant avec des électrodes 3. A l'interface des céramiques 2 et des électrodes 3, sont déposées des couches de liaison 6 de faible épaisseur, typiquement d'épaisseur comprise entre 10 et 50 micromètres d'épaisseur, et de préférence entre 10 et 30 micromètres d'épaisseur. Les électrodes sont découpées dans des tôles de métal laminé, par exemple dans des feuilles d'argent recuit ou dans des feuilles d'alliage cuivre-béryllium, ou encore dans des feuilles d'alliage de titane. L'épaisseur de chaque électrode intermédiaire est supérieure à 20 micromètres d'épaisseur, et de préférence comprise entre 50 micromètres d'épaisseur et 1 mm d'épaisseur.

L'épaisseur des céramiques, qui forment des tranches de contour sensiblement rectangulaire ou carré, est typiquement comprise entre 1 et 5 mm afin de pouvoir fonctionner dans les domaines de contrainte et de fréquence nécessaires pour réaliser un injecteur de carburant. La largeur « 1 » de l'empilement 9, comprenant l'alternance de tranches de céramique et de tranches d'électrodes, est d'environ 15 mm, et la hauteur de cet empilement unitaire peut être de l'ordre de 40 mm. Les contours des tranches de céramique et les contours des tranches d'électrodes sont sensiblement identiques de manière à pouvoir être superposés les uns sur les autres. Les contours peuvent être par exemple rectangulaires, carrés, ou circulaires. La surface latérale peut notamment comporter plusieurs faces planes 21. De légers décalages peuvent exister entre le contour d'une tranche de céramique et les contours des tranches d'électrodes voisines.

Des électrodes latérales 4, réalisées par exemple dans le même type de matériau que les électrodes intermédiaires 3, sont disposées le long de deux faces de l'empilement unitaire, perpendiculaire aux tranches 2 de céramique. Les électrodes latérales sont reliées par des points de soudure 5 avec à une électrode latérale 4 sur deux, de manière à ce que l'électrode latérale soit connectée électriquement à une seule face de chacune des tranches de céramique 2. En appliquant une tension électrique entre les deux électrodes latérales 2, on peut ainsi faire varier la hauteur du transducteur 1.

Les électrodes latérales 4 sont réalisées dans une bande de ruban métallique ondulé perpendiculairement à la longueur du ruban, de manière à ce que chaque fond d'ondulation 7 porte un ou plusieurs points de soudure 5 avec une même électrode intercalaire 3, et chaque sommet d'ondulation 8 éloigne l'électrode latérale 4 de l'électrode intercalaire 3 à laquelle cette électrode latérale n'est pas connectée, de manière à éviter un contact accidentel entre les deux électrodes. En outre, cette configuration permet une déformation élastique des ponts de matière 8 joignant deux électrodes intercalaires 3, qui peuvent ainsi suivre les variations d'épaisseur des tranches de céramique lorsque celles-ci sont excitées électriquement.

L'amplitudes des ondulations de l'électrode latérale 4 peut être choisie de manière ce que la distance minimale entre l'électrode latérale 4 et le groupe d'électrodes intercalaires 3 auquel elle n'est pas connectée, soit supérieure ou égale à 0,5 mm, et de préférence supérieure ou égale à 1 mm.

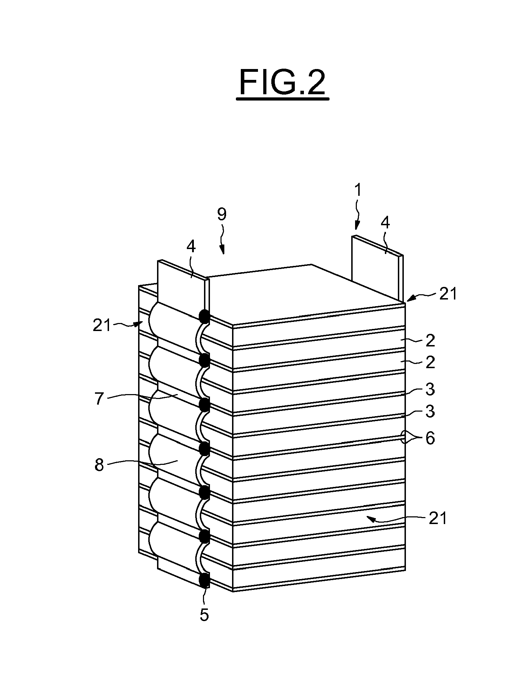

La figure 2 est une vue en perspective du transducteur de la figure 1. On retrouve sur la figure 2 des éléments communs à la figure 1, les mêmes éléments étant désignés par les mêmes références.

On notera que sur les figures 1 et 2, les électrodes latérales 4 sont disposées sur deux faces opposées de l'empilement de céramiques et d'électrodes intercalaires. Selon d'autres variantes de réalisation, ces électrodes latérales pourraient être soudées sur deux faces adjacentes, voire sur une même face de l'empilement 9.

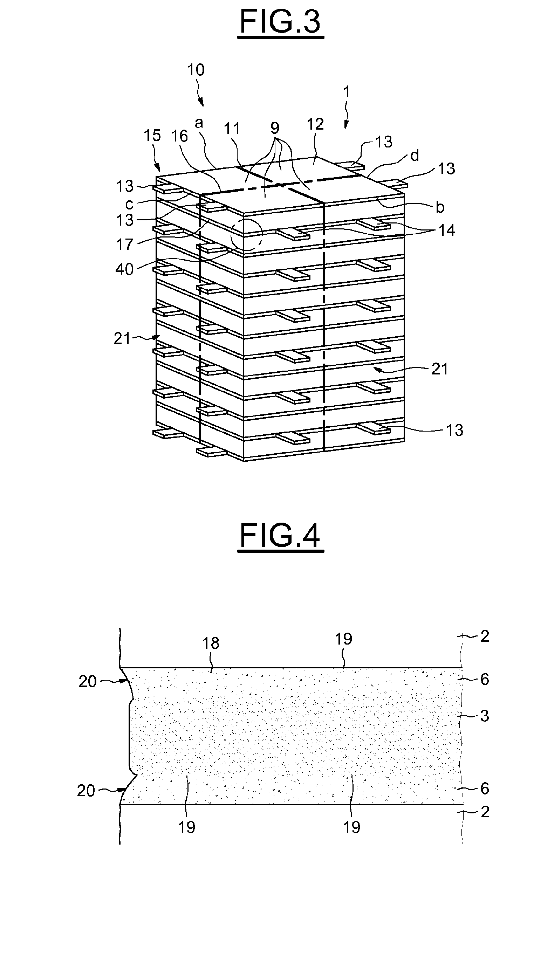

La figure 3 illustre en perspective un empilement initial 10 de céramiques et d'électrodes, réalisé pendant un processus de fabrication d'un transducteur selon l'invention. On retrouve sur la figure 3 des éléments communs aux figures 1 et 2, les mêmes éléments étant alors désignés par les mêmes références. L'empilement initial 10 comporte une première électrode d'extrémité 12 et une seconde électrode intercalaire 17 reliée à la même tranche de céramique. L'électrode d'extrémité 12, la seconde électrode 17, et les électrodes intercalaires 3 dans leur ensemble, portent chacune quatre languettes. Les 4 languettes 13 de l'électrode d'extrémité dépassent par rapport à deux côtés opposés d'un carré 15 définissant un contour des tranches de céramique 2 de l'empilement 10.

Les languettes 13 sont disposées symétriquement par rapport à une ligne médiane 11. La ligne médiane 11 est à la fois la ligne médiane d'un premier côté a et d'un second côté b du carré, cotés dont dépassent les languettes 13. Les languettes 13 sont également disposées de manière symétrique par rapport à une seconde ligne médiane 16, qui est à la fois la ligne médiane d'un troisième côté c et d'un quatrième côté d du carré 15. Les lignes médianes 11 et 16 sont les traces de plans de découpe suivant lesquelles l'empilement initial 10 est, à une étape ultérieure, par exemple avec une scie diamantée, séparé en quatre empilements unitaires 9.

La seconde électrode est une électrode identique à la première électrode 12 mais est disposée décalée d'un angle de rotation de 90° par rapport à la première électrode 12. La seconde électrode comporte quatre languettes 14, qui dépassent ainsi des côtés c et d du carré définissant le contour des céramiques 2.

On réalise ainsi l'empilement initial 10 en déposant alternativement une tranche de céramique, et une tranche d'électrode-identique à l'électrode 12-, et en effectuant une rotation de plus ou moins 90° toutes les deux électrodes, par rapport à l'électrode d'extrémité 12. L'empilement comporte ainsi des électrodes impaires dont les languettes sont alignées avec les languettes 13 de l'électrode d'extrémité 12, et des électrodes paires dont les languettes sont alignées avec les languettes 14 de la seconde électrode 17.

On obtient ainsi l'empilement 10 visible sur la figure 3 Après découpe, cet empilement donne quatre empilements unitaires 9, munis sur une première face, de languettes dépassant de toutes les électrodes d'ordre pair par rapport à l'électrode supérieure, et munis sur une face adjacente, de languettes dépassant de toutes les électrodes d'ordre impair par rapport à l'électrode d'extrémité 12.

Deux électrodes latérales 4 (non représentées sur la figure 3) peuvent alors être connectées à chaque série de languettes. La figure 3 n'est pas à l'échelle : la taille des languettes est surévaluée par rapport aux autres dimensions de l'empilement 10. En pratique, la longueur des languettes peut être prévue de manière à ce qu'une languette, rabattue le long d'une face latérale de l'empilement 9, ne puisse toucher l'électrode suivante. Elle peut par exemple être de longueur légèrement inférieure à l'épaisseur d'une tranche de céramique. Une languette peut par exemple présenter une longueur de l'ordre du millimètre. Selon des variantes de réalisation, la longueur des languettes peut être supérieure à l'épaisseur des tranches de céramique, si la rigidité des languettes est suffisante pour éviter qu'elles ne se rabattent accidentellement le long de la face extérieure du transducteur, dont elles dépassent.

Afin de combler les défauts de planéité entre chaque couche de céramique et ses électrodes associées, une couche d'argent obtenue par frittage d'une nanopoudre d'argent est introduite entre chaque tranche de céramique et les électrodes voisines. Les nanopoudres d'argent, typiquement des poudres d'argent de taille de grain inférieure à 80 nm, de préférence de taille de grain comprise entre 20 et 60 nm, ont la propriété de pouvoir être frittées dans des conditions de température relativement peu élevée et sous des pressions réduites. En particulier, les nanopoudres de tailles de grains comprises entre 30 et 60 nm, permettent d'obtenir des structures frittées à faible porosité résiduelle. Par frittage d'une poudre métallique, on entend l'obtention d'une structure métallique solide en chauffant et en comprimant la poudre métallique, les éléments non métalliques éventuellement présents dans la poudre étant éliminés lors du chauffage.

Une brasure à la nanopoudre d'argent peut ainsi être obtenue en appliquant à l'empilement une pression comprise entre 5 et 10 MPa suivant la direction d'empilement (direction perpendiculaire aux tranches de céramique), à une température comprise entre 200°C et 220°C, pendant une durée de l'ordre de 15 minutes. On emploie par extension le terme de brasure, car même si l'argent constituant la nanopoudre ne passe pas par sa température de fusion "macroscopique", la création d'une masse compacte et son adhésion aux interfaces de céramique et d'électrodes, au moment du frittage, donne une structure comparable à celle qu'on obtiendrait en déposant de l'argent fondu entre l'électrode et la céramique, ceci à une température inférieure à la température de fusion de l'électrode (et de la céramique).

La pression peut par exemple être appliquée par les plateaux d'une presse venant en appui sur des électrodes d'extrémité de l'empilement 10. Les plateaux de la presse peuvent être préchauffés de manière à transmettre l'énergie thermique nécessaire à l'empilement, et/ou l'empilement peut être préchauffé séparément pour être à une température proche de la température de frittage au moment de l'application de la contrainte de pression. La mise sous pression peut également être effectuée à l'intérieur d'une enceinte chauffée, englobant notamment les plateaux de la presse.

Afin de déposer la nanopoudre d'argent, on peut par exemple procéder comme suit. Un film support traité avec une matière anti-adhérente, par exemple du PTFE ou du silicone, est enduit d'une épaisseur régulière, par exemple 100 micromètres de pâte d'argent. La pâte d'argent en question contient essentiellement de la nanopoudre d'argent dans une proportion massique dépassant les 75%, jusqu'à des proportions massiques pouvant être supérieures à 85%. Le reste de la composition comprend notamment des liants, des fluidifiants et des surfactants. Ces composants permettant, d'une part, d'obtenir une pâte suffisamment manipulable pour l'enduction, et permettent, d'autre part d'éviter un frittage prématuré des nanograins d'argent, qui pourrait conduire à une structure excessivement poreuse de la masse frittée finale. De fait, la "pâte" peut être relativement fluide, voire liquide. De préférence, les différents composants sont choisis de manière à former une suspension colloïdale des nanograins d'argent, ce qui évite notamment une agglomération anarchique des nanograins d'argent avant l'opération frittage.

Le film ainsi enduit est ensuite mis au contact d'une des faces d'une tranche de céramique, par exemple au moyen d'un tampon qui vient appuyer sur l'envers (i.e. sur la face non enduite) du film. Une couche résiduelle de pâte reste alors attachée à la céramique. Cette couche est d'épaisseur plus réduite que l'épaisseur d'enduction initiale, par exemple présente une épaisseur de l'ordre de 20 micromètres.

La tranche de céramique enduite peut alors être déposée sur une électrode, ou une électrode peut être déposée sur la tranche de céramique. La seconde face d'une tranche de céramique déjà déposée sur une électrode peut à son tour être enduite de pâte de la même manière, et une seconde électrode peut être disposée par-dessus.

Les contours des électrodes et des tranches de céramique sont sensiblement superposables, et l'on obtient, après empilement d'une alternance de tranches de céramique et d'électrodes, un bloc sensiblement de forme parallélépipède rectangle, tel que par exemple l'empilement 9 des figures 1 ou 2, ou l'empilement 10 de la figure 3.

L'empilement est alors mis en compression sous une presse, en appliquant une pression et un chauffage modérés comme décrit précédemment. Sous l'effet de la pression et de la température, certains composés organiques de la pâte se décomposent, d'autres composants s'évaporent, et la nanopoudre d'argent se solidarise en une masse frittée. Au voisinage du contour des tranches de céramique, d'éventuelles bavures de pâte d'argent sont épargnées par la mise en compression, car elles débordent de l'électrode et/ou de la céramique entre lesquelles elle est disposée. Ces bavures sont donc épargnées par le phénomène de frittage, et forment une masse facilement éliminable, par brossage par exemple. Suivant ses dimensions, l'empilement ainsi solidarisé par frittage peut être utilisé comme partie centrale d'un transducteur, en y soudant simplement deux électrodes latérales, ou peut être redécoupé pour former plusieurs empilements unitaires destinés à différents transducteurs, comme illustré sur la figure 3.

Entre chaque tranche de céramique et chaque électrode, la masse d'argent fritté s'étend sensiblement jusqu'aux bords de la tranche de céramique et de l'électrode. Cette masse d'argent fritté forme éventuellement une légère concavité dans le sens de l'épaisseur, car au centre de la couche d'argent (à mi-épaisseur de la couche d'argent) la pression nécessaire au frittage n'est pas atteinte jusqu'aux bords de la céramique.

Un simple nettoyage, par exemple un nettoyage à la brosse ou un nettoyage de type sablage léger, des faces latérales de l'empilement, permet d'éviter les risques de contact accidentel entre une électrode intercalaire et l'électrode intercalaire voisine. En absence de nettoyage, un tel contact accidentel pourrait être causé par des « bavures » de la pâte d'argent reliant deux électrodes intercalaires voisines. On obtient, à l'issue de ce nettoyage "doux", un empilement dans lequel la couche d'argent fritté est toujours en retrait par rapport à la tranche de céramique sur laquelle elle est déposée, c'est-à-dire que la couche d'argent fritté ne s'étend pas au-delà de la face de la tranche de céramique faisant face à l'électrode. On peut envisager une variante de réalisation dans laquelle le dépôt de la pâte d'argent se ferait alternativement sur une tranche de céramique et sur une tranche d'électrode déjà déposées dans l'empilement. Dans ce cas l'étendue de la couche d'argent fritté se limiterait à l'étendue des faces de céramique ou d'électrodes situées toutes du même côté des couches frittées.

La couche d'argent fritté obtenue présente une compacité remarquable, et une très bonne cohésion au niveau des interfaces avec la tranche de céramique et avec l'électrode.

Ainsi, sur une section, réalisée perpendiculairement aux tranches de céramique, de l'empilement, la proportion surfacique de porosités visibles sur une image de la couche frittée est inférieure en pourcentage à 10%, voire inférieure ou égale à 5%. En outre, la taille maximale des porosités visibles sur une telle coupe est, dans la majorité des cas, inférieure ou égale à 2 micromètres. On observe une très faible quantité de porosité au niveau du contact délimitant la frontière entre la couche frittée et la céramique et au niveau de la frontière entre la couche frittée et l'électrode. La proportion de longueur adhésive d'interface entre l'argent fritté et l'autre matériau, sur une vue en coupe, est dans les deux cas supérieure ou égale à 90%. Les porosités d'interface, comme les porosités dans la masse de l'argent fritté, sont généralement de taille inférieure ou égale à 2 micromètres.

Pour évaluer la qualité de la couche d'argent fritté, on peut par exemple réaliser une coupe micrographique polie perpendiculairement aux tranches de céramique. Sur une telle coupe micrographique, on effectue de préférence l'observation sur une portion centrale de l'empilement, par exemple sur un tiers central de la portion découpée de l'empilement éloignée des bords libres de l'empilement, afin d'éviter d'observer des effets de bord, dus par exemple à une décohésion provoquées lors de la manipulation de l'échantillon en vue de son observation. Cependant, si l'échantillon d'observation est préparé avec soins, la même qualité d'interface est observable jusqu'aux bords de l'échantillon. Pour faciliter l'observation des porosités, on peut par exemple utiliser des images obtenues en microscopie électronique à balayage à partir des électrons rétrodiffusés par l'échantillon.

La figure 4 illustre une vue schématique en coupe d'une portion de transducteur au niveau de la couche de liaison en argent fritté. La coupe est réalisée perpendiculairement aux tranches de céramique, sur une portion de transducteur prélevée par exemple au niveau de la zone 40 de la figure 3 On retrouve sur la figure 4 des éléments communs aux figures 1 et 2, les mêmes éléments étant alors désignés par les mêmes références. On retrouve ainsi deux tranches de céramique 2 entre lesquelles est interposée une électrode intercalaire 3. L'électrode et les deux tranches de céramique sont reliées par deux couches 6 d'argent fritté. L'électrode 3 présente une structure métallique laminée, par exemple une structure d'argent recuit. Les couches d'argent fritté présentent quelques rares porosités 18 et adhèrent presque parfaitement aux tranches de céramique 2 et à l'électrode 3, sauf en de rares zones de décohésion 19. Les surfaces libres 20 de la couche d'argent fritté sont en retrait par rapport aux tranches de céramique voisines.

L'invention ne se limite pas aux exemples de réalisation décrits, et peut se décliner en de nombreuses variantes. Il est possible de revêtir la céramique d'une couche métallique d'accrochage afin d'améliorer encore l'adhésion de la couche frittée d'argent. Une telle couche d'accrochage peut par exemple comprendre une sous couche de chrome de l'ordre d'un micromètre, ainsi qu'une sous couche de surface, par exemple comprenant de l'or, d'une épaisseur de l'ordre du dixième de micromètre. La qualité de l'adhésion de surface est alors évaluée en fonction de l'adhésion de la couche frittée d'argent sur la couche d'accrochage, par exemple sur la couche d'or. L'application de la pâte d'argent peut aussi se faire alternativement sur une tranche de céramique et sur une tranche d'électrode, ou systématiquement sur les tranches d'électrodes. La géométrie et le mode d'assemblage des électrodes latérales peuvent être différent des exemples précités. On peut par exemple envisager de prolonger les languettes des électrodes intercalaires de manière à pouvoir souder l'extrémité de la languette à la base d'une languette faisant saillie deux électrodes intercalaires plus loin, en passant à distance de l'électrode intercalaire voisine.

Le procédé de fabrication de l'empilement piézoélectrique est ainsi à la fois fiable et économique puisqu'il permet de tolérer quelques défauts de planéité et/ou de rugosité de la céramique et/ou des électrodes intercalaires, qu'il assure un bon contact électrique, et qu'il limite les contraintes résiduelles et concentrations de contraintes au niveau des interfaces entre les tranches de céramique et les électrodes intercalaires. En outre, ce procédé ne nécessite pas d'opération de repolarisation des céramiques piézoélectriques ou autrement électroactives. Le procédé permet de préparer des transducteurs de taille importante (largeur supérieure ou égale à 15mm, hauteur supérieure ou égale à 40mm) dans lesquels les tranches de céramique sont brasées avec leurs électrodes associées sur toute leur surface de contact avec ces électrodes.

## Revendications

1. Procédé de fabrication d'un transducteur (1) piézoélectrique, notamment d'un transducteur ultrasonore, comportant un empilement (9) d'électrodes planes (3) entre lesquelles sont interposées des tranches de céramique (2) sensiblement de même surface que les électrodes (3), les contours superposés des tranches de céramique et des tranches d'électrodes définissant des faces latérales (21) sensiblement planes ou cylindriques de l'empilement, le procédé comprenant les étapes suivantes :
- on empile en les alternant une tranche de céramique (2) et une tranche d'électrode (3), en apposant entre chaque tranche de céramique et ses deux électrodes voisines, une composition (6), comprenant au minimum 75% en poids, et de préférence au minimum 80% en poids de nanoparticules d'argent de taille inférieure ou égale à 80 nanomètres, et de préférence de taille de grains inférieure ou égale à 60 nanomètres,
- on comprime l'empilement en le chauffant à une température inférieure ou égale à 280°C, et de préférence comprise entre 200°C et 250°C.

2. Procédé selon la revendication 1, dans lequel ladite composition (6) est une pâte.

3. Procédé selon la revendication 1 ou 2, dans lequel la pression est appliquée de manière unidirectionnelle perpendiculairement aux tranches de céramique, à une valeur comprise entre 2 et 20 MPa, et de préférence comprise entre 5 à 10 MPa, pendant une durée inférieure ou égale à 30 minutes et de préférence inférieure ou égale à 20 minutes.

4. Procédé selon l'une des revendications précédentes, dans lequel, après apposition de la composition (6) sur la céramique, la température moyenne de l'empilement (9) est maintenue en dessous de 280°C, et de préférence en dessous de 250°C.

5. Procédé selon l'une des revendications précédentes, dans lequel, pour apposer une couche de composition (6) entre une tranche de céramique et une tranche d'électrode, on enduit un film support avec la composition, on vient poser le côté enduit du film support sur la tranche de céramique (2), puis on retire le film.

6. Procédé selon l'une des revendications précédentes, dans lequel on utilise des électrodes (3) présentant au moins une languette de connexion (13, 14) dimensionnée pour dépasser de l'empilement (9).

7. Procédé selon la revendication 6, dans lequel on utilise des électrodes (3) carrées présentant quatre languettes de connexion (13, 14), dont deux premières languettes sur une première face du carré et deux secondes languettes sur une seconde face opposée du carré, dans lequel on réalise l'empilement en décalant de +-90° chaque électrode par rapport à l'électrode précédente, et dans lequel on découpe ensuite l'empilement initial (10) en quatre empilements unitaires (9) muni chacun de deux rangées de languettes sur deux faces adjacentes (b, c).

8. Transducteur ultrasonore (1) obtenu par un procédé selon l'une des revendications 1 à 7, comprenant un empilement (9) de tranches de céramique (2) et de tranches d'électrodes intercalaires (3), dans lequel :
- les tranches de céramique (2) sont des couches épaisses d'au moins 1mm d'épaisseur, et de préférence d'au moins 2mm d'épaisseur,
- les tranches d'électrode (3) sont des couches métalliques en métal laminé, d'au moins 20 micromètres d'épaisseur, de préférence d'au moins 50 micromètres d'épaisseur,
- entre chaque tranche céramique (2) et l'électrode voisine ou les électrodes voisines (3), est présente une couche intermédiaire d'argent (6) d'épaisseur au moins 10 micromètres, de préférence d'épaisseur comprise entre 15 et 50 micromètres, recouvrant au moins 95% d'une face de la tranche de céramique disposée en regard de l'électrode.

9. Transducteur selon la revendication 8, dans lequel au moins une couche d'argent (6) intermédiaire présente en moyenne un taux de porosité (18) inférieur à 10% en surface sur une vue en coupe perpendiculaire aux tranches de céramique, et de préférence un taux de porosité inférieur ou égal à 5% en surface observée, les diamètres maximaux des porosités (18) étant inférieurs ou égaux à 2 micromètres, et dans lequel l'interface entre la tranche de céramique et la couche d'argent est exempte de porosités sur plus de 90%, et de préférence, sur plus de 95% de la longueur d'interface.

10. Transducteur selon l'une des revendications 8 ou 9, comportant deux électrodes latérales (4) qui sont chacune en contact électrique avec une électrode intercalaire (3) sur deux, c'est-à-dire avec une seule électrode intercalaire jouxtant une même tranche de céramique (2), chaque électrode latérale (4) présentant une forme ondulée, de manière à laisser un intervalle d'au moins 0,5mm, et de préférence d'au moins 1mm, entre l'électrode latérale et les électrodes intercalaires auxquelles elle n'est pas connectée.

11. Transducteur selon l'une des revendications 8 à 10, dans lequel chaque électrode intercalaire (3) comporte au moins une languette (13, 14) dépassant de l'empilement, le transducteur comportant deux électrodes latérales (4) qui sont chacune en contact électrique avec la languette d'une électrode intercalaire sur deux.

## Patentansprüche

1. Verfahren für die Herstellung eines piezoelektrischen Wandlers (1), insbesondere eines Ultraschallwandlers, der einen Stapel (9) ebener Elektroden (3) umfasst, zwischen denen Keramikscheiben (2) mit im Wesentlichen dem gleichen Oberflächeninhalt wie die Elektroden (3) eingefügt sind, wobei die übereinanderliegenden Umrisse der Keramikscheiben und der Elektrodenscheiben im Wesentlichen ebene oder zylindrische Seitenflächen (21) des Stapels definieren, wobei das Verfahren die folgenden Schritte umfasst:
- abwechselndes Stapeln einer Keramikscheibe (2) und einer Elektrodenscheibe (3), indem zwischen jede Keramikscheibe und ihre zwei benachbarten Elektroden eine Zusammensetzung (6) eingebracht wird, die mindestens 75 Gew.-% und vorzugsweise mindestens 80 Gew.-% Silber-Nanopartikel mit einer Größe, die kleiner oder gleich 80 Nanometer ist, und vorzugsweise mit einer Korngröße, die kleiner oder gleich 60 Nanometer ist, enthält,
- Komprimieren des Stapels durch Erwärmen auf eine Temperatur kleiner oder gleich 280 °C und vorzugsweise im Bereich von 200 °C bis 250 °C.

2. Verfahren nach Anspruch 1, wobei die Zusammensetzung (6) eine Paste ist.

3. Verfahren nach Anspruch 1 oder 2, wobei der Druck in einer einzigen Richtung senkrecht zu den Keramikscheiben mit einem Wert im Bereich von 2 bis 20 MPa und vorzugsweise im Bereich von 5 bis 10 MPa während einer Dauer, die kleiner oder gleich 30 Minuten und vorzugsweise kleiner oder gleich 20 Minuten ist, ausgeübt wird.

4. Verfahren nach einem der vorhergehenden Ansprüche, wobei nach dem Aufbringen der Zusammensetzung (6) auf die Keramik die mittlere Temperatur des Stapels (9) unter 280 °C und vorzugsweise unter 250 °C gehalten wird.

5. Verfahren nach einem der vorhergehenden Ansprüche, wobei, um eine Zusammensetzungsschicht (6) zwischen eine Keramikscheibe und eine Elektrodenscheibe einzubringen, ein Trägerfilm mit der Zusammensetzung bestrichen wird, dann die bestrichene Seite des Trägerfilms auf die Keramikscheibe (2) gelegt wird und dann der Film abgezogen wird.

6. Verfahren nach einem der vorhergehenden Ansprüche, wobei Elektroden (3) verwendet werden, die wenigstens eine Verbindungslasche (13, 14) aufweisen, die so bemessen ist, dass sie den Stapel (9) überragt.

7. Verfahren nach Anspruch 6, wobei quadratische Elektroden (3) verwendet werden, die vier Verbindungslaschen (13, 14) aufweisen, wovon zwei erste Laschen auf einer ersten Fläche des Quadrats vorgesehen sind und zwei zweite Laschen auf einer gegenüberliegenden zweiten Fläche des Quadrats vorgesehen sind, wobei der Stapel dadurch verwirklicht wird, dass jede Elektrode in Bezug auf die vorhergehende Elektrode um ±90° versetzt wird, und wobei anschließend der anfängliche Stapel (10) in vier Einzelstapel (9) zerschnitten wird, die jeweils mit zwei Reihen von Laschen auf zwei benachbarten Flächen (b, c) versehen sind.

8. Ultraschallwandler (1), der durch ein Verfahren nach einem der Ansprüche 1 bis 7 erhalten wird, der einen Stapel (9) aus Keramikscheiben (2) und eingefügten Elektrodenscheiben (3) umfasst, wobei:
- die Keramikscheiben (2) dicke Schichten mit einer Dicke von wenigstens 1 mm und vorzugsweise mit einer Dicke von wenigstens 2 mm sind,
- die Elektrodenscheiben (3) Metallschichten aus einem laminierten Metall mit einer Dicke von wenigstens 20 Mikrometern, vorzugsweise mit einer Dicke von wenigstens 50 Mikrometern sind,
- zwischen jeder Keramikschicht (2) und der oder den benachbarten Elektroden (3) eine Silber-Zwischenschicht (6) mit einer Dicke von wenigstens 10 Mikrometern, vorzugsweise mit einer Dicke im Bereich von 15 bis 50 Mikrometern vorhanden ist, die wenigstens 95 % einer Fläche der Keramikscheibe, die gegenüber der Elektrode angeordnet ist, abdeckt.

9. Wandler nach Anspruch 8, wobei wenigstens eine Silber-Zwischenschicht (6) einen mittleren Porenanteil (18) kleiner als 10 % auf der Oberfläche in einer Schnittansicht senkrecht zu den Keramikscheiben aufweist und vorzugsweise einen Porenanteil kleiner oder gleich 5 % der beobachteten Oberfläche aufweist, wobei die maximalen Durchmesser der Poren (18) kleiner oder gleich 2 Mikrometer sind und wobei die Grenzfläche zwischen der Keramikscheibe und der Silberschicht auf mehr als 90 % und vorzugsweise als mehr als 95 % der Grenzflächenlänge keine Poren aufweist.

10. Wandler nach einem der Ansprüche 8 oder 9, der zwei seitliche Elektroden (4) umfasst, wovon jede mit jeder zweiten Zwischenelektrode (3), d. h. mit einer einzigen Zwischenelektrode, die an dieselbe Keramikscheibe (2) angrenzt, in elektrischem Kontakt ist, wobei jede seitliche Elektrode (4) eine wellige Form aufweist, derart, dass zwischen der seitlichen Elektrode und den Zwischenelektroden, mit denen sie nicht verbunden ist, ein Zwischenraum von wenigstens 0,5 mm und vorzugsweise von wenigstens 1 mm vorhanden ist.

11. Wandler nach einem der Ansprüche 8 bis 10, wobei jede Zwischenelektrode (3) wenigstens eine Lasche (13, 14) umfasst, die den Stapel überragt, wobei der Wandler zwei seitliche Elektroden (4) umfasst, die jeweils mit einer Lasche jeder zweiten Zwischenelektrode in elektrischem Kontakt sind.

## Claims

1. Method for fabricating a piezoelectric transducer (1), notably an ultrasound transducer, comprising a stack (9) of planar electrodes (3) between which are interposed ceramic wafers (2) with substantially the same surface area as the electrodes (3), the superposed contours of the ceramic wafers and of the electrode wafers defining substantially planar or cylindrical side faces (21) of the stack, the method comprising the following steps:
- a ceramic wafer (2) and an electrode wafer (3) are stacked alternately, placing between each ceramic wafer and its two adjacent electrodes, a composition (6), comprising at least 75% by weight, and preferably at least 80% by weight, of silver nanoparticles of a size less than or equal to 80 nanometers, and preferably with a grain size less than or equal to 60 nanometers,
- the stack is compressed by heating it to a temperature less than or equal to 280°C, and preferably between 200°C and 250°C.

2. Method according to Claim 1, in which said composition (6) is a paste.

3. Method according to Claim 1 or 2, in which the pressure is applied unidirectionally, perpendicularly to the ceramic wafers, at a value of between 2 and 20 MPa, and preferably between 5 to 10 MPa, for a duration less than or equal to 30 minutes and preferably less than or equal to 20 minutes.

4. Method according to one of the preceding claims, in which, after placing the composition (6) on the ceramic, the mean temperature of the stack (9) is maintained below 280°C, and preferably below 250°C.

5. Method according to one of the preceding claims, in which, to place a layer of composition (6) between a ceramic wafer and an electrode wafer, a support film is coated with the composition, the coated side of the support film is placed on the ceramic wafer (2), then the film is removed.

6. Method according to one of the preceding claims, in which electrodes (3) are used that have at least one connection tab (13, 14) dimensioned to extend the beyond the stack (9).

7. Method according to Claim 6, in which square electrodes (3) are used that have four connection tabs (13, 14), two first tabs on a first face of the square and two second tabs on an opposite second face of the square, in which the stack is produced by staggering each electrode by +-90° relative to the preceding electrode, and in which the initial stack (10) is then cut into four unitary stacks (9) each provided with two rows of tabs on two adjacent faces (b, c).

8. Ultrasound transducer (1) obtained by a method according to one of Claims 1 to 7, comprising a stack (9) of ceramic wafers (2) and of separator electrode wafers (3), in which:
- the ceramic wafers (2) are thick layers at least 1 mm thick, and preferably at least 2 mm thick,
- the electrode wafers (3) are metallic layers of rolled metal, at least 20 micrometers thick, preferably at least 50 micrometers thick,
- between each ceramic wafer (2) and the adjacent electrode or the adjacent electrodes (3), there is an intermediate layer of silver (6) at least 10 micrometers thick, preferably between 15 and 50 micrometers thick, covering at least 95% of a face of the ceramic wafer arranged facing the electrode.

9. Transducer according to Claim 8, in which at least one intermediate layer of silver (6) has on average a void ratio (18) less than 10% by surface area on a cross-sectional view at right angles through the ceramic wafers, and preferably a void ratio less than or equal to 5% by observed surface area, the maximum diameters of the voids (18) being less than or equal to 2 micrometers, and in which the interface between the ceramic wafer and the layer of silver is free of voids over more than 90%, and preferably over more than 95% of the interface length.

10. Transducer according to one of Claims 8 or 9, comprising two side electrodes (4) which are each in electrical contact with one separator electrode (3) in every two, that is to say with a single separator electrode adjoining one and the same ceramic wafer (2), each side electrode (4) having a rippled form, so as to leave a gap of at least 0.5 mm, and preferably of at least 1 mm, between the side electrode and the separator electrodes to which it is not connected.

11. Transducer according to one of Claims 8 to 10, in which each separator electrode (3) comprises at least one tab (13, 14) extending beyond the stack, the transducer comprising two side electrodes (4) which are each in electrical contact with the tab of one separator electrode in every two.
